# DEMANDE DE BREVET EUROPEEN

(11) **EP 1 811 560 A1**
(43) Date de publication de la demande: **25.07.2007**
(21) Numéro de dépôt: 07100462.6
(22) Date de dépôt: 12.01.2007
(51) Int. Cl.: H01L 21/762

(54) **Procédé de fabrication d'un substrat composite à propriétés électriques améliorées**

(30) Priorité: 23.01.2006 FR 0600595
(71) Demandeur: S.O.I.TEC. Silicon on Insulator Technologies S.A., 38190 Bernin (FR)
(72) Inventeur: Allibert, Frédéric, 38100, Grenoble (FR); Kerdiles, Sébastien, 38330, Saint-Ismier (FR)
(74) Mandataire: Bomer, Françoise Marie

(57) **Abrégé**

L'invention concerne un procédé de fabrication d'un substrat composite (4), comprenant au moins une couche mince d'isolant (32), intercalée entre un substrat support (1), et une couche active de matériau semi-conducteur (21).

Ce procédé est remarquable en ce qu'il comprend, dans l'ordre qui suit, les étapes de :
- formation ou dépôt d'une couche d'isolant (32) sur un substrat source et éventuellement d'une couche d'isolant (31) sur ledit substrat support (1),
- traitement thermique de guérison de ladite couche d'isolant (32) et éventuellement de ladite couche d'isolant (31) formée sur le substrat support (1),
- activation par plasma d'au moins l'une des deux faces à coller,
- collage par adhésion moléculaire des deux substrats, de façon que ladite couche d'isolant (32) soit située entre eux,
- retrait d'une partie dudit substrat source, de façon à ne conserver qu'une épaisseur de matériau constituant ladite couche active (21).

Ce procédé permet d'obtenir un substrat (4) à propriétés électriques améliorées.

## Description

La présente invention concerne un procédé de fabrication, à basse température, d'un substrat dit "hybride" ou "composite", du type comprenant au moins une couche d'isolant, enterrée, c'est-à-dire intercalée, entre un substrat support et une couche active de matériau semi-conducteur, issue d'un substrat source.

Plus précisément, l'invention concerne un procédé permettant d'obtenir un substrat composite tel que précité, dont les propriétés électriques sont sensiblement améliorées. Ce substrat est utilisé dans les domaines de l'optique, l'électronique et l'optoélectronique.

Dans la suite de la description et des revendications, le terme "isolant" désigne un matériau électriquement isolant, présentant éventuellement une permittivité diélectrique élevée.

Par ailleurs, les substrats composites visés par le procédé conforme à l'invention sont tous caractérisés par le fait qu'ils ne peuvent subir, sans dommages, de traitement thermique à haute température. Ils peuvent être subdivisés en deux groupes.

Le premier groupe comprend les substrats composites, pour lesquels au moins l'un des substrats entre le substrat donneur et le substrat receveur ne peut être exposé à une température dite "élevée", voire même à haute température.

On peut distinguer plusieurs types de ces substrats donneurs ou receveurs :
a) ceux comprenant des éléments susceptibles de diffuser :
   La température "élevée" est alors la température à partir de laquelle la diffusion de cet élément devient dommageable. C'est le cas des substrats comprenant :
      - des profils de dopage (en bore ou en arsenic, par exemple),
      - des couches métalliques enterrées (plan de masse, grilles enterrées), ou
      - des empilements de couches semi-conductrices ayant des interfaces abruptes que l'on souhaite préserver (silicium (Si) sur silicium germanium (SiGe), ou silicium (Si) sur germanium (Ge)).
b) ceux qui sont instables ou liquides à haute température :
   - le germanium, par exemple, dont la température de fusion est d'environ 900°C et que l'on ne peut soumettre à des températures supérieures à 750°C, voire même supérieures à 600°C,
   - les substrats comprenant des couches dont on souhaite préserver l'état de contrainte (relaxé, ou contraint en tension ou en compression) et qui pourraient être perturbées si le substrat était exposé à une haute température.

Le second groupe comprend les substrats composites qui ne peuvent être exposés à une température élevée après collage du substrat source sur le substrat support :
a) soit à cause des différences de coefficients de dilatation thermique entre ces deux matériaux. C'est le cas notamment des substrats du type "silicium sur quartz", connus sous l'acronyme "SOQ".
b) soit lorsque l'on veut éviter la diffusion d'éléments d'un substrat vers un autre.

Les propriétés électriques que le procédé conforme à l'invention vise à améliorer sont plus précisément :
- La densité de charges (connue sous l'abréviation "*Q box"* en anglais) dans la couche enterrée isolante. On cherche à obtenir une valeur inférieure à 5.10¹¹ charges par cm².
- La tension de claquage, c'est-à-dire la tension à partir de laquelle la résistivité de l'isolant chute fortement. On cherche à obtenir des valeurs maximales. A titre d'exemple, pour une couche enterrée d'oxyde de silicium, on cherche de préférence à obtenir une valeur le plus proche de 10 MV/cm.
- La mobilité des trous et/ou des électrons dans la couche active. A titre d'exemple illustratif, il serait souhaitable d'obtenir une mobilité électronique supérieure à 500 cm².V⁻¹.s⁻¹, dans du silicium dopé en bore avec une concentration de l'ordre de 10¹⁵at/cm³.
- La valeur de "DIT", d'après la terminologie anglaise de "*interface trap density*", qui désigne la densité de pièges au niveau d'une interface entre deux couches. Dans le cadre de la présente invention, on cherche principalement à améliorer les valeurs de DIT, au niveau de l'interface entre la couche d'isolant enterrée et la couche active et éventuellement en plus, la valeur de DIT à l'interface entre la couche d'isolant et une couche voisine.

Dans la suite de la description, on se focalise sur les valeurs de DIT, parce que c'est l'un des principaux paramètres sur lequel les étapes de formation du substrat conformes à l'invention ont une influence. De plus, ce paramètre à une incidence sur la mobilité. Toutefois, l'invention vise bien de manière générale à améliorer les performances électriques du substrat final.

Les pièges ont la capacité de retenir ou de libérer des porteurs de charge au niveau des interfaces. Ils ont un impact extrêmement néfaste sur les propriétés électriques des futurs composants électroniques qui seront réalisés sur le substrat composite.

La densité de pièges au niveau d'une interface, ci-après dénommée à des fins de simplification, la "valeur de DIT", s'exprime en nombre de pièges/eV.cm². Plus la valeur de DIT est élevée et plus les propriétés électriques du substrat sont mauvaises.

A titre d'exemple, une valeur de 10¹² eV⁻¹.cm⁻² est une valeur élevée qui correspond à de mauvaises propriétés électriques du substrat. Actuellement, les meilleures valeurs de DIT obtenues sont de l'ordre de 10¹⁰.eV⁻¹.cm⁻², pour les interfaces entre des oxydes de très bonne qualité, dits "oxydes de grille" et leur support. On trouve de tels oxydes, par exemple, dans les transistors, les mémoires, les capacités et autres types de composants formant des circuits intégrés.

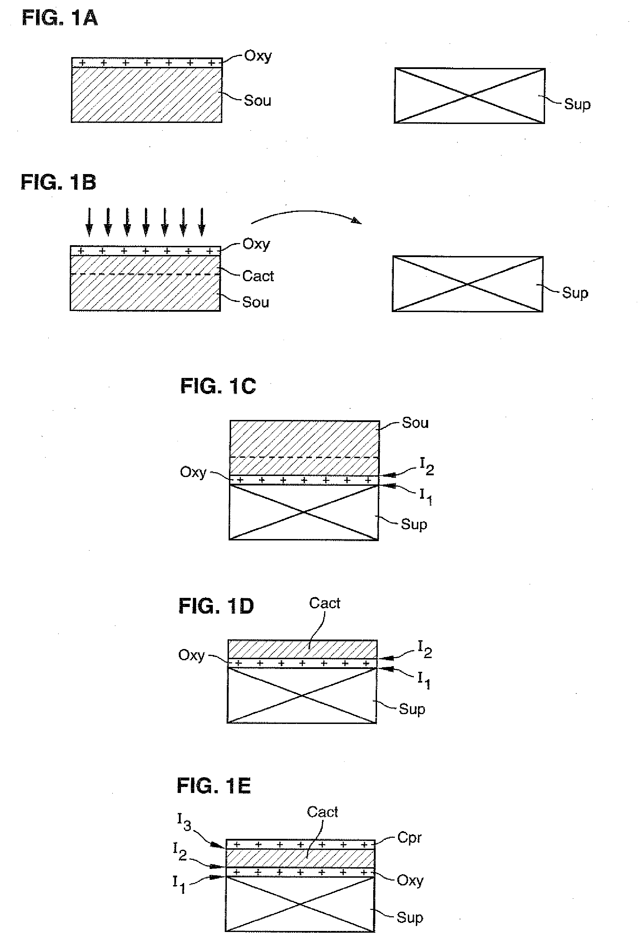

Les figures 1A à 1E jointes illustrent les différentes étapes de l'un des modes de fabrication d'un substrat de type SOI, connu de l'état de la technique.

Comme représenté sur les figures 1A et 1B, ce procédé consiste à oxyder un substrat source **Sou**, de façon à former à sa surface une couche d'oxyde **Oxy,** puis à y effectuer une implantation d'espèces atomiques, de façon à délimiter une couche active **Cact**. La couche d'oxyde est généralement assez épaisse, de l'ordre de 150 nm.

Après collage sur un substrat support **Sup** (figure 1C) et détachement du reste du substrat source **Sou**, on obtient un substrat composite comprenant une couche d'oxyde **Oxy,** intercalée entre un support et une couche active et qui présente avec chacun d'eux, une interface de contact, respectivement **I₁** et **I_{2,}** (figure 1D).

Enfin, on peut former sur la surface supérieure du substrat composite ainsi obtenu, une couche destinée à protéger cette surface, lors des traitements thermiques de finition du substrat. Le substrat est ainsi recouvert d'une couche protectrice **Cpr** et il existe une interface **I₃** entre cette couche protectrice **Cpr** et la couche active **Cact**.

On connaît déjà d'après l'état de la technique, des procédés permettant d'améliorer, c'est-à-dire d'abaisser, les valeurs de DIT, au niveau de certaines interfaces d'un substrat composite.

L'un d'entre eux, connu sous l'acronyme "FGA", d'après la terminologie anglaise de "*Forming Gas Anneal*", consiste à effectuer un traitement thermique de réparation /guérison des interfaces à basse température, de l'ordre de 450°C, dans une atmosphère contenant de l'hydrogène et un gaz neutre.

Toutefois, lorsqu'un tel procédé est réalisé à 450°C, son effet sur l'amélioration de la valeur de DIT s'exerce uniquement sur l'interface **I₃** entre la couche protectrice **Cpr** et la couche active **Cact** et non sur les interfaces **I₁** et **I₂,** ou seulement très faiblement. En effet, ce procédé de traitement FGA perd de son efficacité à chaque interface rencontrée. Il est donc relativement inefficace sur les interfaces profondes.

Une autre possibilité consiste à effectuer un traitement thermique de recuit à une haute température, c'est-à-dire supérieure à 900°C, voire supérieure à 1000°C. Un tel traitement permet d'améliorer la valeur de DIT à l'interface **I**₂, mais ne peut être appliqué à un certain nombre de substrats, comme exposé précédemment.

Il en est ainsi de certaines structures formées par collage, ou des substrats composites contenant des matériaux instables à haute température, tels que par exemple le germanium (Ge) ou le silicium contraint (sSi, d'après l'anglais "*strained silicon*")*.*

C'est également le cas des substrats formés de plusieurs matériaux présentant des différences significatives de coefficient de dilatation thermique (silicium sur quartz par exemple) ou de substrats contenant des éléments dont on veut éviter la diffusion, par exemple des profils de dopants ou une structure incluant un plan de masse métallique.

Il n'est donc pas possible d'appliquer à ce type de structures, les traitements d'amélioration du DIT utilisant la haute température.

De plus, il est également nécessaire d'utiliser pour leur fabrication, des techniques de collage qui ne nécessitent pas de traitement thermique à haute température.

On connaît ainsi d'après l'article de Suni et al, "Effect of plasma activation on hydrophilic bonding of Si and SiO2", Electrochemical Society Proceedings Volume, 2001-27, pp 22-30, une solution qui consiste à faire précéder l'étape de mise en contact intime des surfaces à coller, par une étape d'activation plasma d'au moins l'une des surfaces à coller, à savoir celle du support **Sup** et/ou de la source **Sou**.

On obtient alors une énergie de collage élevée, voisine d'1 J/m², à l'interface **I₁**, et ce, même après un recuit à 200°C pendant 1 heure seulement.

Cependant, l'activation par plasma a pour effet de détériorer de manière assez significative, les caractéristiques électriques de l'interface **I₁** et notamment ses valeurs de DIT.

On pourra se reporter à ce sujet à l'article de K. Schjölberg-Henriksen et al., "Oxide charges induced by plasma activation for wafer bonding", Sensors and Actuators A 102 (2002) 99-105, qui montre l'effet négatif de l'activation par plasma sur les propriétés électriques des substrats.

Toutefois, cet article montre également qu'il est possible de corriger les effets néfastes de l'activation plasma sur les propriétés électriques des substrats, par un traitement ultérieur de recuit de type "FGA". Cet article montre que pour un oxyde de bonne qualité, réalisé sur un substrat de silicium, la valeur de DIT est de l'ordre de quelques 10¹⁰. eV⁻¹.cm⁻² après l'activation plasma, mais que malheureusement les forces de collage après le traitement "FGA" sont diminuées de plus de 50%.

Or, il est également important d'obtenir un collage fort dans une structure composite, lorsque l'on envisage ultérieurement un amincissement de l'une des couches le constituant, pour éviter les problèmes de zones non transférées.

L'invention a pour but de résoudre les inconvénients précités de l'état de la technique.

Elle a plus précisément pour but de fournir un procédé d'obtention d'un substrat composite comprenant une couche d'isolant enterrée, cette dernière présentant de bonnes propriétés électriques principalement au niveau de l'interface avec la couche active qu'elle supporte.

Ce procédé s'applique plus particulièrement aux substrats composites dont au moins une couche ne supporte pas les traitements thermiques à température élevée, voisine de 400 à 500°C, voire même à haute température, c'est -à-dire supérieure ou égale à 900°C.

Enfin, ce procédé doit également permettre d'obtenir un substrat composite dans lequel la couche active reportée adhère très fortement à la couche d'isolant sur laquelle elle repose.

A cet effet, l'invention concerne un procédé de fabrication d'un substrat composite, à propriétés électriques améliorées, du type comprenant au moins une couche mince d'isolant, intercalée entre un premier substrat, dit "support" et une couche de matériau semi-conducteur, dite "couche active".

Conformément à l'invention, ce procédé comprend, dans l'ordre qui suit, les étapes de :
- formation ou dépôt d'une couche d'isolant sur un second substrat, dit "substrat source" et éventuellement d'une couche d'isolant sur ledit substrat support,
- traitement thermique de guérison de ladite couche d'isolant et éventuellement de ladite couche d'isolant formée sur le substrat support,
- activation par plasma d'au moins l'une des deux faces destinées à être collées l'une contre l'autre, parmi la face avant de la couche d'isolant du substrat source, et la face avant du substrat support ou la face avant de la couche d'isolant du substrat support,
- collage par adhésion moléculaire dudit substrat support et dudit substrat source l'un contre l'autre, de façon que ladite couche d'isolant soit située entre ledit substrat support et ledit substrat source,
- retrait d'une partie, dite "arrière", dudit substrat source, de façon à ne conserver qu'une épaisseur de matériau constituant ladite couche active et à obtenir ledit substrat composite.

Selon d'autres caractéristiques avantageuses et non limitatives de l'invention, prises seules ou en combinaison :
- le traitement thermique de guérison comprend un traitement de type FGA, réalisé par recuit sous une atmosphère de gaz neutre et hydrogène, à une température comprise entre 400 et 600°C, pendant une durée comprise entre environ trente minutes et deux heures ;
- le traitement thermique de guérison comprend un traitement thermique à une température supérieure à 900°C, sous une atmosphère de gaz neutre, en présence éventuelle d'oxygène, pendant environ 30 minutes à 1 heure ;
- le traitement thermique de guérison comprend un traitement thermique de type RTA mis en oeuvre pendant quelques secondes à quelques minutes environ ;
- le traitement d'activation plasma consiste à introduire le substrat à traiter à l'intérieur d'une enceinte d'activation et à l'y exposer pendant 5 à 60 secondes environ, à un plasma formé à partir d'un gaz pur, choisi parmi l'oxygène (O₂), l'azote (N₂), l'argon (Ar) et l'hélium (He) ou un mélange de ces gaz, ce gaz étant introduit dans l'enceinte selon un débit compris entre 10 et 1000 sccm, la pression régnant à l'intérieur de l'enceinte étant comprise entre 10 et 200 mTorr, le plasma étant initié puis entretenu par l'application d'une puissance de radiofréquence comprise entre 100 et 3000 W ;
- la couche d'isolant est un oxyde ;
- la couche d'isolant est un matériau diélectrique à forte permittivité ;
- le matériau diélectrique à forte permittivité est choisi parmi le groupe comprenant le dioxyde de hafnium (HfO₂), l'oxyde d'yttrium (Y₂O₃) ; le trioxyde de strontium et de titane (SrTiO₃), l'alumine (Al₂O₃), le dioxyde de zirconium (ZrO₂), le pentoxyde de tantale (Ta₂O₅), le dioxyde de titane (TiO₂), leurs nitrures et leurs siliciures ;
- le retrait de la partie arrière du substrat source est effectué par meulage et/ou polissage ;
- le procédé comprend la formation d'une zone de fragilisation à l'intérieur du substrat source, avant l'étape d'activation par plasma et le retrait de la partie arrière du substrat source, par détachement le long de cette zone de fragilisation ;
- la zone de fragilisation est obtenue par implantation d'espèces atomiques à l'intérieur du substrat source ;
- ladite couche active est réalisée dans un matériau choisi parmi le silicium, le germanium et le silicium contraint ;
- le procédé comprend une étape de dopage de tout ou partie de l'un des substrats source ou support.

D'autres caractéristiques et avantages de l'invention apparaîtront de la description qui va maintenant en être faite, en référence aux dessins annexés, qui en représentent, à titre indicatif mais non limitatif, un mode de réalisation possible.

Sur ces dessins :
- les figures 1A à 1E sont des schémas représentant les différentes étapes de fabrication d'un substrat de type SOI, conformément à un mode de réalisation connu de l'état de la technique,
- les figures 2A à 2F sont des schémas représentant les différentes étapes du procédé de fabrication, conformes à un premier mode de réalisation de l'invention,
- les figures 3A à 3G sont des schémas représentant des variantes de réalisation du procédé précité.

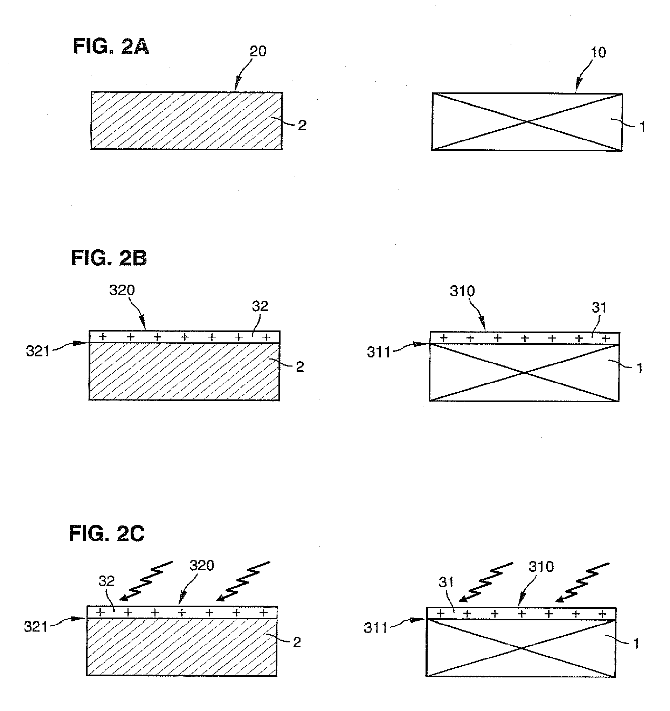

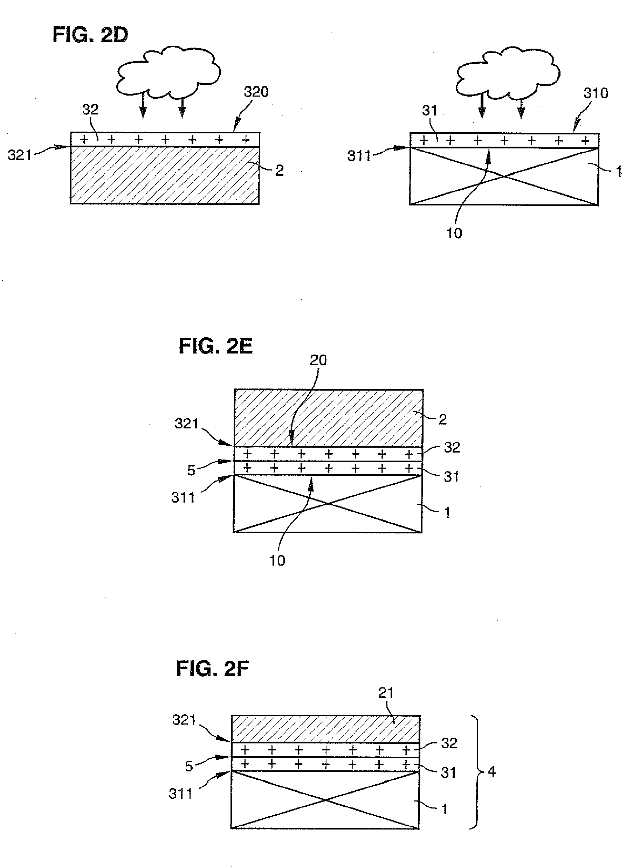

Les différentes étapes du procédé de fabrication d'un substrat composite conforme à l'invention vont maintenant être décrites succinctement en faisant référence à la figure 2.

En se reportant à la figure 2A, on peut voir que le procédé utilise un premier substrat 1, dit "substrat support" et un second substrat 2, dit "substrat source".

Les faces supérieures des substrats support 1 et source 2 portent respectivement les références numériques 10 et 20.

Comme représenté sur la figure 2B, on forme ou l'on dépose ensuite une couche d'isolant, au moins sur le substrat source 2 et éventuellement sur le substrat support 1.

La couche d'isolant présente sur le substrat support 1 porte la référence 31 et celle présente sur le substrat source 2, la référence 32.

Les surfaces libres ou faces avant des couches d'isolant 31, 32 portent respectivement les références numériques 310 et 320.

L'interface entre la couche d'isolant 31 et le substrat support 1 porte la référence numérique 311 et celle entre les couches 32 et 2, la référence 321.

Comme cela apparaît mieux sur la figure 2C, on procède ensuite à un traitement thermique du substrat source 2 recouvert de la couche d'isolant 32, afin de "guérir" cette couche 32, c'est-à-dire d'améliorer ses caractéristiques électriques et celles de l'interface 321. Dans la suite de la description et des revendications, ce traitement sera dénommé "traitement thermique de guérison".

Si la couche d'isolant 31 est présente sur le substrat support 1, elle peut éventuellement subir également un traitement thermique de guérison.

La figure 2D illustre l'étape d'activation par plasma qui est effectuée sur au moins l'une des deux faces destinées à être collées l'une contre l'autre, c'est-à-dire sur au moins l'une des faces 320, 310 ou 10 (en l'absence de couche d'isolant 31).

On procède ensuite au collage par adhésion moléculaire des deux substrats 1 et 2, de façon que leurs faces avant 10, 20 soient en regard l'une de l'autre (voir figure 2E). L'interface de collage porte la référence 5.

Enfin, on procède au retrait d'une partie, dite "arrière" du substrat source 2, de façon à ne conserver qu'une épaisseur de ce matériau, qui constitue une couche active 21, dans le substrat composite final, référencé 4 (voir figure 2F).

Les différentes étapes du procédé et les matériaux choisis vont maintenant être décrits plus en détail.

Dans le substrat composite 4, le substrat 1 joue un rôle de support mécanique, comme c'est le cas habituellement dans l'état de la technique.

De plus, il est même possible que ce substrat support 1 contienne des éléments qui seront constitutifs des composants électroniques finaux (comme par exemple des électrodes, un plan de masse, un canal...).

Le substrat support 1 est avantageusement réalisé en matériau semi-conducteur.

La couche active 21 du substrat composite 4 est issue du substrat source 2, comme cela sera décrit ultérieurement. Ce substrat source 2 est également en matériau semi-conducteur.

A titre d'exemple purement illustratif, on citera ci-après différents exemples de matériaux susceptibles d'être utilisés comme substrats 1 et 2 :
- substrat support 1 : silicium (Si), carbure de silicium (SiC), germanium (Ge), couche épitaxiée quelconque, par exemple une couche de germanium (Ge), de silicium germanium (SiGe), ou de nitrure de gallium (GaN) sur un substrat de silicium, voire même une couche de silicium contraint.
- substrat source 2 : silicium (Si), germanium (Ge), carbure de silicium (SiC), nitrure de gallium (GaN), silicium germanium (SiGe), arséniure de gallium (AsGa) ou phosphure d'indium (InP).

On notera que les substrats 1 et 2 peuvent également être multicouches.

L'invention s'applique plus particulièrement à la réalisation de substrats composites dont l'une des couches de matériau ne supporte pas les traitements thermiques à températures élevées ou hautes. O n pourra citer comme exemples de matériaux susceptible d'être un constituant des substrats 1 ou 2, les matériaux suivants : silicium contraint, germanium, couche métallique ou dopée, couches contigües de semi-conducteurs susceptibles de diffuser l'une dans l'autre.

Les couches d'isolant 31, 32 sont choisies, par exemple, parmi des couches d'oxyde ou de nitrure, telles que de l'oxyde de silicium (SiO₂) ou du nitrure de silicium (Si₃N₄) ; de l'oxynitrure de germanium (GeₓO_{y}N_{z}) ; du nitrure d'aluminium (AlN) ; ; des matériaux diélectriques à forte permittivité (« high k » selon la terminologie anglaise), tels que par exemple, du dioxyde de hafnium (HfO₂), de l'oxyde d'yttrium (Y₂O₃) ; du trioxyde de strontium et de titane (SrTiO₃) ; de l'alumine (Al₂O₃), du dioxyde de zirconium (ZrO₂), du pentoxyde de tantale (Ta₂O₅), du dioxyde de titane (TiO₂), leurs nitrures et leurs siliciures.

La nature de chaque couche d'isolant 31 ou 32 sera choisie en fonction de la nature des matériaux utilisés pour le substrat support 1 et le substrat source 2. De plus, l'isolant 32 sera choisi de manière à optimiser les performances électriques de l'interface 321.

A titre d'exemple, pour réaliser un substrat final 4 du type GeOI (germanium sur isolant), on pourra former une couche fine de SiO₂ sur le substrat support en silicium et une couche de HfO₂ sur le substrat source en germanium.

De préférence, les isolants 31, 32 sont d'excellente qualité, en ce qui concerne leurs propriétés électriques. Plus précisément, l'isolant 32 présente d es valeurs de DIT au niveau de l'interface 321 les plus faibles possibles.

A titre d'exemple illustratif, lorsque les couches 1 et 2 sont en silicium et que les couches d'isolant 31, 32 sont en dioxyde de silicium, les valeurs de DIT au niveau de l'interface 321 sont inférieures ou égales à 10¹¹ .eV⁻¹.cm⁻², voire même inférieures ou égales à quelques 10¹⁰ .eV⁻¹.cm⁻².

Ainsi, lorsque l'isolant est un oxyde, il est formé avec toutes les précautions prises pour former les oxydes de qualité optimale, comme par exemple les oxydes de grille. On pourra se référer, à ce sujet, à l'article de Green et al. "Ultrathin (<4nm) SiO2 and Si-O-N gate dielectric layers for silicon microelectronics: Understanding the processing, structure, and physical and electrical limits", Journal of Applied Physics, volume 90, n°5, 1 septembre 2001, pages 2086 et suivantes.

Les surfaces des substrats 1 et 2, sur lesquelles l'oxyde sera formé, sont préparées par un nettoyage approfondi, par exemple à l'aide d'un traitement dans un bain chimique dénommé "RCA", afin d'éviter toute contamination.

Le traitement "RCA" consiste à traiter les surfaces, successivement avec :
- un premier bain d'une solution connue sous l'acronyme "SC1" (d'après la terminologie anglo-saxonne de "*Standard Clean* 1" qui signifie "solution de nettoyage standard 1"), et qui comprend un mélange d'hydroxyde d'ammonium (NH₄OH), de peroxyde d'hydrogène (H₂O₂) et d'eau déionisée,
- un second bain d'une solution connue sous l'acronyme "SC2" (d'après la terminologie anglo-saxonne de "*Standard Clean* 2" qui signifie "solution de nettoyage standard 2"), et qui comprend un mélange d'acide chlorhydrique (HCl), de peroxyde d'hydrogène (H₂O₂) et d'eau déionisée.

Les oxydes sont ensuite obtenus par un traitement thermique d'oxydation, respectivement du substrat support 1 et/ou du substrat source 2.

Les couches d'isolants 31, 32 peuvent également être obtenues par dépôt chimique en phase vapeur à basse pression (LPCVD), ou par un procédé de dépôt de couches atomiques, connu sous l'acronyme ALD ("*atomic layer deposition*" en anglais).

### Traitement thermique de guérison:

Ce traitement de guérison peut être effectué de plusieurs façons, comme représenté sur la figure 2C

Une première possibilité consiste à effectuer un recuit thermique de type "FGA" ("*Forming Gaz Anneal*")*.*

De préférence, ce traitement FGA est réalisé sous une atmosphère de gaz neutre et d'hydrogène, à une température comprise entre 400 et 600°C, de préférence voisine de 450°C, pendant une durée comprise entre trente minutes et deux heures environ, de préférence environ 90 minutes.

Ce traitement est effectué par exemple, dans un four tubulaire à atmosphère contrôlée.

La couche d'isolant qui subit un tel traitement présente ainsi des valeurs de "DIT" relativement faibles, au niveau de l'interface avec le substrat sur lequel elle a été formée.

Les valeurs de "DIT" atteintes sont inférieures à 10¹¹.eV⁻¹.cm⁻², voire même inférieures à quelques 10¹⁰ .eV⁻¹.cm⁻².

Une seconde possibilité consiste à effectuer un recuit thermique à haute température, c'est-à-dire à une température supérieure à 900°C, voire même 1100°C, sous une atmosphère de gaz neutre (par exemple de l'argon) ou de gaz neutre et d'oxygène, pendant environ 30 minutes à 1 heure. Ce traitement est effectué par exemple, dans un four tubulaire à atmosphère contrôlée.

Cette seconde possibilité n'est bien sûr utilisée que si l'un des deux substrats peut supporter de telles températures et ce traitement n'est appliqué qu'au substrat, éventuellement recouvert d'une couche d'isolant, qui peut le supporter.

Ce traitement à haute température peut éventuellement être réalisé en complément du traitement FGA, et préférentiellement avant celui-ci.

Enfin, on notera que selon une variante, les deux types de recuit thermique précités peuvent être mis en oeuvre dans un équipement de recuit rapide (procédé connus sous l'acronyme "RTA", d'après la terminologie anglaise de "*Rapid Thermal Annealing*"*.* Le procédé de recuit de guérison dure alors entre quelques secondes et quelques minutes environ, typiquement 30 secondes.

### Traitement d'activation plasma:

Le traitement d'activation plasma (figure 2D) est effectué dans des conditions qui préservent les caractéristiques électriques et notamment les valeurs de DIT de l'interface entre la couche d'isolant et la couche voisine, (lorsqu'une telle interface existe). En effet, ces valeurs ont déjà été abaissées (et donc améliorées) à l'issue du traitement précédent de guérison.

L"'activation plasma" d'une surface se définit comme l'exposition de cette surface à un plasma, ceci pouvant se faire notamment dans une enceinte sous vide ou à pression atmosphérique.

Cette activation est réalisée en contrôlant divers paramètres d'exposition, tels que la nature, le débit ou la pression du gaz alimentant l'enceinte à l'intérieur de laquelle est réalisée l'activation, ainsi que la puissance appliquée.

Dans le cadre de l'invention, le substrat recouvert de la couche d'isolant à activer est introduit dans l'enceinte, puis on envoie à l'intérieur de celle-ci, un gaz pur, typiquement de l'oxygène (O₂), éventuellement de l'azote (N₂), de l'argon (Ar) ou de l'hélium (He) ou encore un mélange de ces gaz, tel que oxygène et hélium, oxygène et argon ou hélium et azote, par exemple, à partir desquels sera généré le plasma, dès l'application de la puissance.

Le débit du gaz utilisé est fonction du volume de l'enceinte d'activation et de la taille du substrat.

De préférence, le gaz est envoyé avec un débit compris entre 10 et 1000 sccm (centimètre cube standard par minute, d'après la terminologie anglaise de "*standard cubic centimeter per minute*")*.* A titre d'exemple, on utilise typiquement un débit de 75 sccm pour un substrat de 200 mm de diamètre et de 200 sccm pour un substrat de 300 mm de diamètre.

La pression régnant dans l'enceinte lors du traitement plasma est contrôlée, pour se situer dans la gamme de 10 à 200 mTorr, typiquement voisine de 50 mTorr, (1 mTorr étant égal à 1,33.10⁻¹ Pa).

Le plasma est initié puis entretenu par l'application d'un puissance de RF (radiofréquence) comprise entre 100 et 2000 W, de préférence voisine de 250 W dans le cas de substrats de 200 mm de diamètre et comprise entre 100 et 3000 W, de préférence voisine de 500 W dans le cas de substrats de 300 mm de diamètre.

La surface de la face à coller est alors exposée au plasma pendant 5 à 60 secondes environ, de préférence 10 à 30 secondes.

Il convient également de limiter au strict nécessaire, la durée d'exposition au traitement par plasma.

De préférence, celle-ci est inférieure à une minute, ou mieux encore inférieure à 30 secondes. Une exposition prolongée risquerait d'occasionner une accumulation de charges électriques dans l'isolant et une augmentation de la densité de charge de l'isolant (QBOX en anglais), ce qui va à l'encontre de l'amélioration des performances électriques exposées dans l'introduction.

### Retrait de la partie arrière du substrat source :

Ce retrait peut s'effectuer par exemple par meulage et/ou polissage.

Une variante de réalisation du retrait de cette partie arrière consiste à utiliser la formation d'une zone de fragilisation.

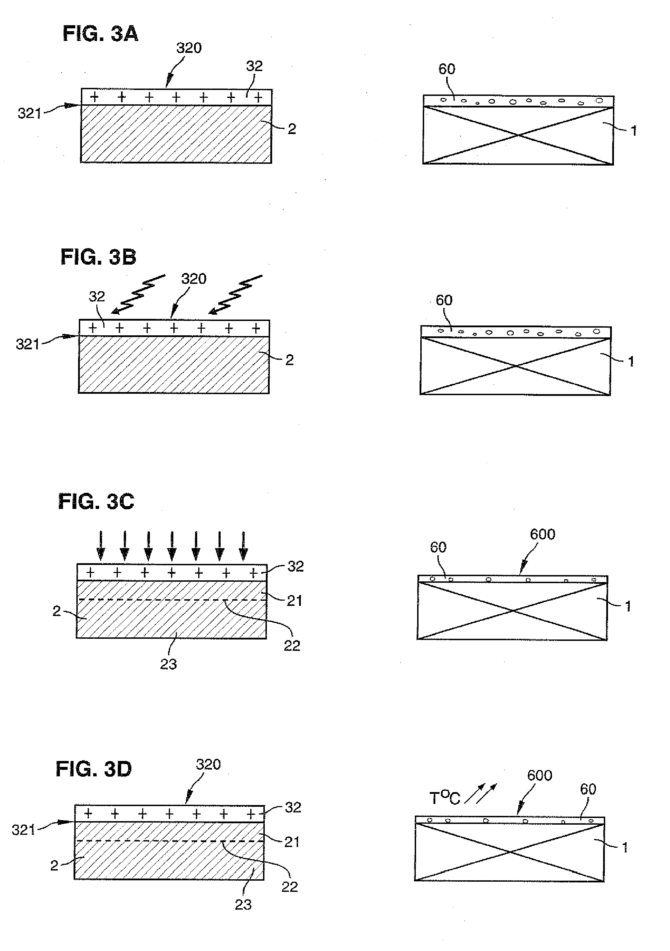

Cette variante est illustrée sur les figures 3A à 3G, sur lesquelles les éléments identiques à ceux décrits précédemment portent les mêmes références numériques.

La zone de fragilisation 22 formée à l'intérieur du substrat source 2 délimite la couche active 21 d'une partie arrière 23.

La zone 22 peut être formée par une zone poreuse, voir à ce sujet l'article de K. Sakaguchi et al., "Eltran® by splitting porous Si layers", the ElectroChemical Society, Inc PV99-3, Silicon-on-insulator technology and devices, P.L.Hemment, pp 117-121.

La zone 22 est toutefois avantageusement formée par implantation d'espèces atomiques légères, de préférence des ions hydrogène et/ou d'hélium, afin de ne pas détériorer l'oxyde 32, (voir figure 3C).

Pour les modalités de l'implantation, on pourra se référer à l'article de C. Maleville et C. Mazuré, "Smart Cut™ technology: from 300 nm ultrathin SOI production to advanced engineered substrates", Solid-State Electronics 48 (2004) 1055-1063, qui décrit le procédé Smart Cut^{™} utilisé ici.

Lorsque l'on utilise l'implantation d'espèces atomiques, celle-ci est réalisée après le traitement thermique de guérison de la figure 3B.

L'étape de détachement de la partie arrière 23, le long de la zone 22 consiste en l'application de contraintes d'origine thermique ou mécanique, par exemple un traitement de recuit ou l'introduction d'une lame au niveau de ladite zone de fragilisation 22.

Deux exemples particuliers de réalisation vont maintenant être décrits.

### Exemple 1 : réalisation d'un substrat dont la couche active comporte un plan de masse, (connu sous l'acronyme "GP -SOI", d'après la terminologie anglaise de "ground plane silicon on insulator")

Cet exemple va être décrit en faisant référence aux figures 3A à 3G.

Un substrat support 1 en silicium est recouvert d'un dépôt d'une mince couche 60 de silicium d'environ 1 µm, fortement dopée en bore, (voir figures 3A et 3B), pour y définir le plan de masse.

Cette couche fortement dopée présente une face avant à coller 600, (voir figure 3C). On lui fait subir un polissage ou un lissage pour diminuer la rugosité de ladite surface 600 et la ramener à des valeurs compatibles avec le collage.

Comme représenté sur la figure 3D, le substrat support 1 recouvert de la coupe dopée 60 est ensuite soumis à un traitement de recuit thermique haute température (RTA), typiquement à 1050°C pendant environ 10 secondes.

Par ailleurs, on utilise un substrat source 2 en silicium, oxydé par oxydation sèche, de façon à le recouvrir d'une couche 32 de SiO₂ d'environ 50 nanomètres (50 nm).

La couche 32 est ensuite soumise à un traitement de guérison du type FGA, à 450°C, pendant environ 1 h 30, (voir figure 3B). L'oxyde 32 présente des valeurs de DIT de quelques 10¹⁰ eV⁻¹. cm⁻².

Comme représenté sur la figure 3C, le substrat 2 subit une implantation d'ions hydrogène, selon une dose de 5,5. 10¹⁶ H⁺/cm², et une énergie d'implantation de 37 keV, de façon à définir la zone de fragilisation 22.

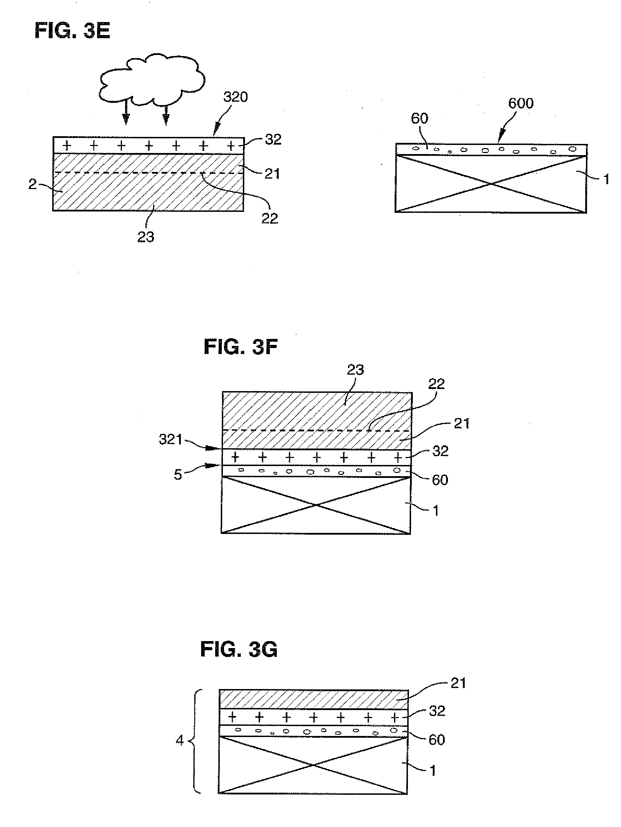

La surface libre 320 de la couche d'oxyde 32 est soumise à une activation plasma (figure 3E). Le substrat 2 faisant 300 mm de diamètre, on a utilisé les paramètres suivants : plasma d'oxygène, débit de 200 sccm, puissance de 500W, pression de 50 mTorr, pendant 30 secondes.

Après collage par adhésion moléculaire (figure 3F) et détachement de la partie arrière du substrat source par traitement thermique au voisinage de 500°C pendant un temps court, on obtient le substrat composite représenté sur la figure 3G. On notera qu'on limite volontairement le traitement thermique post-collage, pour éviter toute diffusion du bore dans l'oxyde ou dans la couche active, ce qui risquerait d'amoindrir les performances électriques.

Ce substrat composite présente des valeurs de DIT voisines de quelques 10¹⁰ eV⁻¹. cm⁻².

### Exemple 2 : réalisation d'un substrat composite comprenant une couche active de silicium sur un empilement d'oxyde et de quartz.

On utilise le même substrat source 2 que dans l'exemple 1 et on lui fait subir les mêmes traitements, à l'exception du traitement de guérison qui est effectué par un recuit haute température à 1100°C et de la formation de la zone de fragilisation effectuée par co-implantation d'hélium (1,5. 10¹⁶ He⁺/cm²) et d'hydrogène (1. 10¹⁶ H⁺/cm²).

On utilise par ailleurs un substrat support 1 en quartz dont la face avant 10 est soumise à une activation plasma selon les mêmes paramètres que ceux utilisés dans l'exemple 1 pour le substrat 2.

Le substrat composite obtenu présente des valeurs de DIT au niveau de l'interface entre l'oxyde et le silicium de l'ordre de quelques 10¹⁰ eV⁻¹. cm⁻².

Conformément à l'invention, le fait d'effectuer systématiquement le traitement de guérison, avant l'activation plasma, permet de ne pas réduire la valeur de l'énergie de collage, tout en conservant des valeurs de "DIT" extrêmement faibles. Le collage est donc fort, l'amincissement du substrat source s'en trouve ultérieurement facilité.

## Revendications

1. Procédé de fabrication d'un substrat composite (4), à propriétés électriques améliorées, du type comprenant au moins une couche mince d'isolant (32), intercalée entre un premier substrat (1), dit "support" et une couche de matériau semi-conducteur (21), dite "couche active", **caractérisé en ce qu'**il comprend, dans l'ordre qui suit, les étapes de :
- formation ou dépôt d'une couche d'isolant (32) sur un second substrat (2), dit "substrat source" et éventuellement d'une couche d'isolant (31) sur ledit substrat support (1),
- traitement thermique de guérison de ladite couche d'isolant (32) et éventuellement de ladite couche d'isolant (31) formée sur le substrat support (1),
- activation par plasma d'au moins l'une des deux faces destinées à être collées l'une contre l'autre, parmi la face avant (320) de la couche d'isolant (32) du substrat source (2), et la face avant (10) du substrat support (1) ou la face avant (310) de la couche d'isolant (31) du substrat support (1),
- collage par adhésion moléculaire dudit substrat support (1) et dudit substrat source (2) l'un contre l'autre, de façon que ladite couche d'isolant (32) soit située entre ledit substrat support (1) et ledit substrat source (2),
- retrait d'une partie (23), dite "arrière", dudit substrat source (2), de façon à ne conserver qu'une épaisseur de matériau constituant ladite couche active (21) et à obtenir ledit substrat composite (4).

2. Procédé selon la revendication 1, **caractérisé en ce que** le traitement thermique de guérison comprend un traitement de type FGA, réalisé par recuit sous une atmosphère de gaz neutre et hydrogène, à une température comprise entre 400 et 600°C, pendant une durée comprise entre environ trente minutes et deux heures.

3. Procédé selon la revendication 1 ou 2, **caractérisé en ce que** le traitement thermique de guérison comprend un traitement thermique à une température supérieure à 900°C, sous une atmosphère de gaz neutre, en présence éventuelle d'oxygène, pendant environ 30 minutes à 1 heure.

4. Procédé selon la revendication 2 ou 3, **caractérisé en ce que** le traitement thermique de guérison comprend un traitement thermique de type RTA mis en oeuvre pendant quelques secondes à quelques minutes environ.

5. Procédé selon l'une des revendications précédentes, **caractérisé en ce que** le traitement d'activation plasma consiste à introduire le substrat à traiter à l'intérieur d'une enceinte d'activation et à l'y exposer pendant 5 à 60 secondes environ, à un plasma formé à partir d'un gaz pur, choisi parmi l'oxygène (O₂), l'azote (N₂), l'argon (Ar) et l'hélium (He) ou un mélange de ces gaz, ce gaz étant introduit dans l'enceinte selon un débit compris entre 10 et 1000 sccm, la pression régnant à l'intérieur de l'enceinte étant comprise entre 10 et 200 mTorr, le plasma étant initié puis entretenu par l'application d'une puissance de radiofréquence comprise entre 100 et 3000 W.

6. Procédé selon l'une des revendications précédentes, **caractérisé en ce que** la couche d'isolant (31, 32) est un oxyde.

7. Procédé selon l'une des revendications 1 à 5, **caractérisé en ce que** la couche d'isolant (31, 32) est un matériau diélectrique à forte permittivité.

8. Procédé selon la revendication 7, **caractérisé en ce que** le matériau diélectrique à forte permittivité est choisi parmi le groupe comprenant le dioxyde de hafnium (HfO₂), l'oxyde d'yttrium (Y₂O₃) ; le trioxyde de strontium et de titane (SrTiO₃), l'alumine (Al₂O₃), le dioxyde de zirconium (ZrO₂), le pentoxyde de tantale (Ta₂O₅), le dioxyde de titane (TiO₂), leurs nitrures et leurs siliciures.

9. Procédé selon l'une des revendications précédentes, **caractérisé en ce que** le retrait de la partie arrière (23) du substrat source (2) est effectué par meulage et/ou polissage.

10. Procédé selon l'une des revendications 1 à 8, **caractérisé en ce qu'**il comprend la formation d'une zone de fragilisation (22) à l'intérieur du substrat source (2), avant l'étape d'activation par plasma et le retrait de la partie arrière (23) du substrat source (2), par détachement le long de cette zone de fragilisation (22).

11. Procédé selon la revendication 10, **caractérisé en ce que** la zone de fragilisation (22) est obtenue par implantation d'espèces atomiques à l'intérieur du substrat source (2).

12. Procédé selon l'une des revendications précédentes, **caractérisé en ce que** ladite couche active (21) est réalisée dans un matériau choisi parmi le silicium, le germanium et le silicium contraint.

13. Procédé selon l'une des revendications précédentes, **caractérisé en ce qu'**il comprend une étape de dopage de tout ou partie de l'un des substrats source (2) ou support (1).
